**Europäisches Patentamt**

**European Patent Office**

**Office européen des brevets**

(11) Publication number: **0 098 155**
**B1**

# EUROPEAN PATENT SPECIFICATION

(45) Date of publication of patent specification: **24.01.90**

(21) Application number: **83303736.9**

(22) Date of filing: **28.06.83**

(51) Int. Cl.⁵: **H 03 K 3/295**

(54) Schmitt trigger circuit.

(30) Priority: **29.06.82 JP 110611/82**

(43) Date of publication of application:
**11.01.84 Bulletin 84/02**

(45) Publication of the grant of the patent:
**24.01.90 Bulletin 90/04**

(84) Designated Contracting States:
**DE FR GB**

(56) References cited:
**EP-A-0 025 667**
**EP-A-0 041 363**
**US-A-3 555 294**

**PATENTS ABSTRACTS OF JAPAN, vol. 6, no.
176 (E-130) 1054r, 10th September 1982; & JP -
A - 57 93 727 (FUJITSU K.K.) 10-06-1982**

(73) Proprietor: **FUJITSU LIMITED**
**1015, Kamikodanaka Nakahara-ku
Kawasaki-shi Kanagawa 211 (JP)**

(72) Inventor: **Yasuda, Yasushi
Shinkouji-jutaku 5-304 1405, Shinkouji-machi
Machida-shi Tokyo 194-01 (JP)**
Inventor: **Enomoto, Hiromu
Kawaracho-danchi 15-1225 1, Kawara-cho
Saiwai-ku Kawasaki-shi Kanagawa 210 (JP)**
Inventor: **Yoshiki, Shimauchi
Himawari-rejidensu 13 2-888,
Shinmarukohigashi
Nakahara-ku Kawasaki-shi Kanagawa 211 (JP)**
Inventor: **Tahara, Akinori
7-15-25, Kotsubo
Zushi-shi Kanagawa 249 (JP)**

(74) Representative: **Fane, Christopher Robin King
et al
HASELTINE LAKE & CO. Hazlitt House 28
Southampton Buildings Chancery Lane
London, WC2A 1AT (GB)**

## Description

This invention relates to a Schmitt trigger circuit, in which the input threshold voltages associated with the rise or fall of the output voltages have a hysteresis characteristic such that the input threshold voltage ($V_L$) when the input voltage falls from a high level (H) to a low level (L) is lower than the input threshold voltage ($V_H$) when the input voltage rises from a low level to a high level.

A Schmitt trigger circuit, for example as described in EP—A—0041363, having a high input threshold voltage ($V_H$) associated with the rise of the input voltage and a low input threshold voltage ($V_L$) associated with the fall of the input voltage, has advantages of reduced noise sensitivity and consequent avoidance of oscillation at input voltages close to the threshold voltages, due to the hysteresis characteristic of the input threshold voltages as, as hereinafter described in detail with respect to conventional Schmitt trigger circuits. Therefore, such a Schmitt trigger circuit can be used advantageously as an input buffer for various logic circuits, such as flip-flops, shift registers, counters, etc., particularly when the input of the buffer is connected to a long bus line along which input waveforms tend to deteriorate.

However, in a conventional Schmitt trigger circuit, there is a disadvantage of a sudden increase in the input current when the input voltage falls from the high input threshold voltage ($V_H$) to the low input threshold voltage ($V_L$), Because of this sudden increase in the input current, a drive circuit for supplying input current to the input stage of the Schmitt trigger buffer circuit must have a capability of drawing a larger current than would be required when using a different type of buffer circuit.

Accordingly, an object of the present invention is to provide a Schmitt trigger circuit, having a hysteresis characteristic, in which the problem of such a sudden increase is substantially avoided.

According to the present invention, there is provided a Schmitt trigger circuit of the type having:

an input stage comprising an input transistor providing a controllable path, controlled by a first control electrode of the transistor, which path is connected in series with a load resistor between first and second power lines;

an output stage connected between an output point and one of the first and second power supply lines;

a control arrangement, including a second transistor having a second control electrode connected to the said first control electrode by way of a first diode, such that the second transistor is switched on or off, when the circuit is in use, in dependence upon an input signal applied to the first control electrode, which arrangement provides a controllable path connected to control the said output stage so that the output stage is switched between first and second states in dependence upon the said input signal; and

hysteresis circuitry providing two alternative parallel unidirectional current paths, comprising respectively a second diode and a third transistor, for conducting current in the same direction between said load resistor and one end of a common path the other end of which is connected to the anode of the said first diode and to the said second control electrode, which circuitry includes path control means coupled to the said controllable path of the said control arrangement and operative in dependence thereon to ensure that the said third transistor conducts such current when the said input signal is decreasing and to ensure that the said second diode conducts such current when the input signal is increasing, the respective voltage drops along the said alternative current paths being different from one another so as to provide respective different threshold voltages for Schmitt trigger switching of the output stage;

characterised by level shift means connected in the said common path for introducing a further voltage drop in series with that one of the said alternative current paths which is conducting current, thereby to reduce current flowing along the said common path, and through the said first diode to the first control electrode, while the said signal applied to the first control electrode is decreasing.

Reference will now be made, by way of example, to the accompanying drawings, in which:

Figures 1a and 1b are circuit diagrams of previously considered Schmitt trigger circuits;

Figures 2a and 2b are waveform diagrams illustrating operation of the circuits shown in Figures 1a and 1b, respectively;

Figures 3a and 3b are circuit diagrams of embodiments of the present invention;

Figures 4a and 4b are waveform diagrams of operation of the circuits shown in Figures 3 and 3b, respectively; and

Figures 5a and 5b are circuit diagrams illustrating other embodiments of the present invention.

Before describing a Schmitt trigger circuit of the present invention, previously considered Schmitt Trigger circuits will first be described with reference to the accompanying drawings.

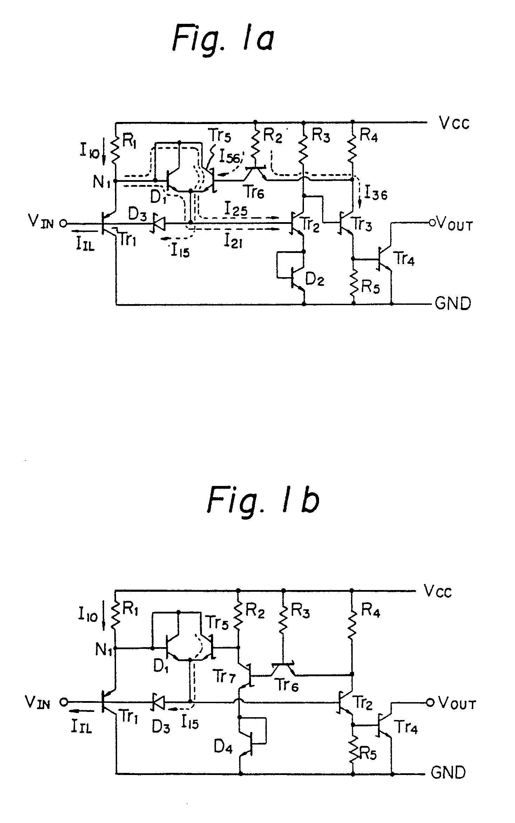

Figure 1a illustrates a non-inverting type Schmitt trigger circuit and Figure 1b an inverting type Schmitt trigger circuit. Such trigger circuits are described for example in EP—A—0041363. Referring to Figure 1a, the circuit has an input stage comprising a PNP input transistor $Tr_1$ and load resistor $R_1$ connected between the emitter of the transistor $Tr_1$ and a power supply $V_{CC}$. $Tr_2$ and $Tr_3$ denote NPN transistors of a phase-splitting control arrangement $Tr_4$ denotes an NPN transistor in an output stage, $Tr_5$ denotes an NPN transistor for providing a hysteresis characteristic, and $Tr_6$ denotes an NPN transistor for controlling the NPN transistor $Tr_5$. These transistors $Tr_2$ to $Tr_6$ are composed of Schottky barrier diode (SBD) clamped transistors.

A PN diode $D_1$ which is formed by shorting the collector and base of an NPN transistor is connected between the emitter and collector of the transistor $Tr_5$. A PN diode $D_2$ which is formed by shorting the collector and base of an NPN transistor is connected between the transistor $Tr_2$ and the ground.

A Schottky barrier diode (SBD) $D_3$ is connected in the forward direction between the base of the transistor $Tr_2$ and the base of the transistor $Tr_1$, which latter base is an input terminal of the Schmitt trigger circuit. This diode $D_3$ is used to discharge the base of the transistor $Tr_2$ so as to speed up the turning off of the transistor $Tr_2$ when the input voltage $V_{IN}$ falls. The forward voltage drop of such a Schottky barrier diode $D_3$ is, as is well known, lower than that of a conventional PN diode and might typically be 0.4V.

The anode (base shorted with collector) of the diode $D_1$ is connected to a node $N_1$ between the emitter of the transistor $Tr_1$ and the load resistor $R_1$. The cathode (emitter) of the diode $D_1$ is connected to the base of the transistor $Tr_2$. This diode $D_1$ is used to determine a threshold voltage $V_H$ when the input voltage $V_{IN}$ rises.

While the input voltage $V_{IN}$ is low (hereinafter referred to as L), for example, is zero volt, the transistor $Tr_1$ is in the on state. In this case, the voltage $V_{N1}$ at the node $N_1$ is expressed as

$$V_{N1}=V_{IN}+V_{BE}=V_{BE},$$

where $V_{BE}$ is the base to emitter voltage of the transistor $Tr_1$. Since the forward voltage drop of the diode $D_1$ is $V_{BE}$ and the transistor $Tr_5$ is in the off state, the transistor $Tr_2$ is in the off state. In order to turn on this transistor $Tr_2$, the voltage $V_{N1}$ at the node $N_1$ should be equal to or higher than the sum the forward voltage drops ($V_{BE}$) of the transistor $Tr_2$ and the diodes $D_1$ and $D_2$, namely $V_{N1}=3V_{BE}$. As the input voltage $V_{IN}$ at the input terminal is lower than $V_{N1}$ by $V_{BE}$, if the input voltage $V_{IN}$ is $V_{IN}=2V_{BE}$, the transistor $Tr_2$ turns on. In other words, the threshold voltage $V_H$ as the input voltage $V_{IN}$ rises is $V_H=2V_{BE}$.

While $V_{IN}=L$, the transistor $Tr_2$ is in the off state as aforementioned and the transistor $Tr_3$, which provides a controllable path connected to control the transistor $Tr_4$, is in the on state, causing $Tr_4$ to be on and the output voltage $V_{out}$ to be low (L). In this case, a current $I_{36}$ flows via a resistor $R_2$ and the base-emitter junction of the transistor $Tr_6$ into the controllable path of the transistor $Tr_3$. The current designated by $I_{56}$ in Figure 1a, however, is zero so that the transistor $Tr_5$ is in the off state.

When the input voltage $V_{IN}$ is increased from $V_{IN}=L$ to $V_{IN}=2V_{BE}$ (in this case, $V_{N1}=3V_{BE}$), the transistor $Tr_2$ starts to turn on. During this transitional period, the base current to the transistor $Tr_2$ is supplied via the load resistor $R_1$ and the diode $D_1$ as indicated by $I_{21}$. As the transistor $Tr_2$ starts to turn on, the base current of the transistor $Tr_3$ decreases until finally the transistor $Tr_3$ is turned off. Thus, the transistor $Tr_4$ turns off, causing the output voltage $V_{out}$ to become high (H). In this case, the flow path of the current passing through

the resistor $R_2$ is altered to conduct current not via the transistor $Tr_3$ (as $I_{36}$) but to the base of the transistor $Tr_5$ (as $I_{56}$) via the base-collector junction of the transistor $Tr_6$, causing the transistor $Tr_5$ to turn on. Since the collector-to-emitter voltage $V_{CE}$ of the transistor $Tr_5$ during the on state is lower than the forward voltage drop $V_{BE}$ of the diode $D_1$, the base current to the transistor $Tr_2$ is supplied via the resistor $R_1$ and the collector-to-emitter path of the transistor $Tr_5$ as indicated by $I_{25}$ after the transistor $Tr_5$ turns on, instead of $I_{21}$. While $V_{IN}=H$ the above state is maintained.

While the input voltage $V_{IN}$ changes from $V_{IN}=H$, to $V_{IN}=L$, the transistor $Tr_2$ turns off. This turning off occurs when the voltage $V_{N1}$ at the node $N_1$ decreases to a value equal to or lower than $V_{CE}+2V_{BE}$, which is the sum of the collector emitter voltage $V_{CE}$ of the transistor $Tr_5$, and the forward voltage drops $V_{BE}$ of the transistor $Tr_2$ and of the diode $D_2$. Therefore, when the input voltage $V_{IN}$ becomes

$$V_{IN}\leqq V_{BE}+V_{CE},$$

the transistor $Tr_2$ turns off. In other words, the threshold voltage $V_L$ as the input voltage $V_{IN}$ falls is

$$V_L=V_{BE}+V_{CE}.$$

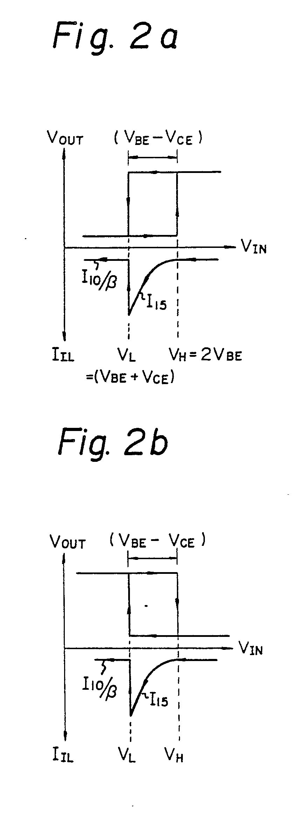

Figure 2a illustrates the hysteresis characteristic between the input voltage $V_{IN}$ and the output voltage $V_{out}$, and the input current $I_{IL}$ when the input voltage falls, according to the Schmitt trigger circuit of Figure 1a. The difference between the threshold voltages $V_H$ and $V_L$ for rising and falling input voltages $V_{IN}$ respectively is indicated as

$$V_H-V_L=2V_{BE}-(V_{BE}+V_{CE})=V_{BE}-V_{CE}.$$

In general, $V_{BE}$ is about 0.8 V, and $V_{CE}$ is about 0.2 to 0.3V. Therefore, the difference $V_H-V_L$ which corresponds to a noise margin is at least about 0.4 V.

In the aforementioned Schmitt trigger circuit, there occurs a problem in that the input current $I_{IL}$ suddenly increases greatly when the input voltage $V_{IN}$ falls.

While $V_{IN}=H$, as the current $I_{25}$ flows via the transistor $Tr_2$ and the diode $D_2$, the voltage at the emitter of the transistor $Tr_5$ is kept at $2V_{BE}$. In this case, the voltage drop across the diode $D_3$ is less than the forward voltage drop $V_F$ necessary to turn it on; hence the diode $D_3$ is in the off state and no current flows therethrough. When the input voltage $V_{IN}$ decreases from $V_{IN}=H$ to a value at which

$$V_{IN}=2V_{BE}-V_F,$$

the diode $D_3$ turns on and a part ($I_{15}$) of the current passing through the transistor $Tr_5$, which is in the on state while $V_{IN}=H$, flows to the input terminal via the diode $D_3$ during the transitional period from when $V_{IN}$=H to when $V_{IN}$=L. The above phenomenon occurs when the relationship between

$$V_{BETr_1}, V_{CETr_5}, \text{ and } V_{FD3} \text{ is}$$

$$V_{BETr_1} \gtreqless V_{CETr_5} + V_{FD3},$$

where

$V_{BETr_1}$ is the base to emitter voltage of the transistor $Tr_1$,

$V_{CETr_5}$ is the collector to emitter voltage of the transistor $Tr_5$, and

$V_{FD3}$ is the forward voltage drop of the diode $D_3$.

For typical values of $V_{BETr_1}(=0.8)$, $V_{CETR_5}(=0.2$ while $Tr_5$ is ON) and $V_{FD3}$ (=0.4V), this relationship will normally hold while $Tr_5$ is turned on.

The normal input current $I_{IL}$ whlie $V_{IN}$=L is equal to the base current of the transistor $Tr_1$, and is the mitter current $I_{10}$ divided by the factor $\beta$ which current is normally extremely small. The symbol $\beta$ is used conventionally to denote the current gain amplification factor, normally around 10. However, since the above-mentioned current $I_{15}$ flows out directly, without being multiplied by the factor $1/\beta$, the input current $I_{IL}$ is thereby greatly increased momentarily, during the above-mentioned transitional period. When the frequency of variation of the input voltage $V_{IN}$ is high, the input current $I_{IL}$ is therefore subject to rapidly repeated transient increases. If the input current $I_{IL}$ increases substantially, the current drawn by a preceding stage connected to the input terminal becomes very large. Thus the preceding stage must be capable of handling such an extremely large load, and the problems associated with connecting a large number of Schmitt trigger circuits to an earlier stage are exacerbated.

The same operations are effected in an inverting type Schmitt trigger circuit shown in Figure 1b. This differs from the non-inverting type in that a transistor $Tr_7$ and a diode $D_4$ are connected in series with resistor $R_2$, and that transistor $Tr_6$ is connected between resistor $R_3$ and the base of transistor $Tr_7$. In this circuit, while $V_{IN}$=L, the transistor $Tr_1$ is in the on state and the transistor $Tr_2$ is in the off state because there is no supply of base current. Therefore, the transistor $Tr_4$ is also in the off state, causing the output voltage $V_{out}$ to be high (H). Contrary to this, when $V_{IN}$ changes to $V_{IN}$=H, the transistor $Tr_1$ turns off and the transistor $Tr_2$ turns on, because base current is supplied through the resistor $R_1$ and the diode $D_1$. Thus, the transistor $Tr_4$ turns on, causing the output voltage $V_{out}$ to change the low state.

On the other hand, whle $V_{IN}$ is low (L) and thus the transistor $Tr_2$ is in the off state, the current passing through the transistor $Tr_6$ flows to the base of the transistor $Tr_7$. Therefore, both the transistor $Tr_7$ and the diode $D_4$ turns on. Thus, the transistor $Tr_5$ turns off. When $V_{IN}$ changes to $V_{IN}$=H, since the transistor $Tr_2$ turns on, the transistor $Tr_6$ stops supplying the base current to the transistor $Tr_7$. As a result, the transistor $Tr_7$ and the diode $D_4$ turn off, and, thus, the transistor $Tr_5$

turns on. In this circuit of Figure 1b, any current flowing from the collector of the transistor $Tr_5$ through the diode $D_3$ to the input is added, at the input, to that flowing in the parallel current path through the emitter-base junction of the transistor $Tr_1$, so a significant current surge $I_{15}$ is produced as shown in the lower portion of Figure 2b when the input voltage $V_{IN}$ falls from H to L.

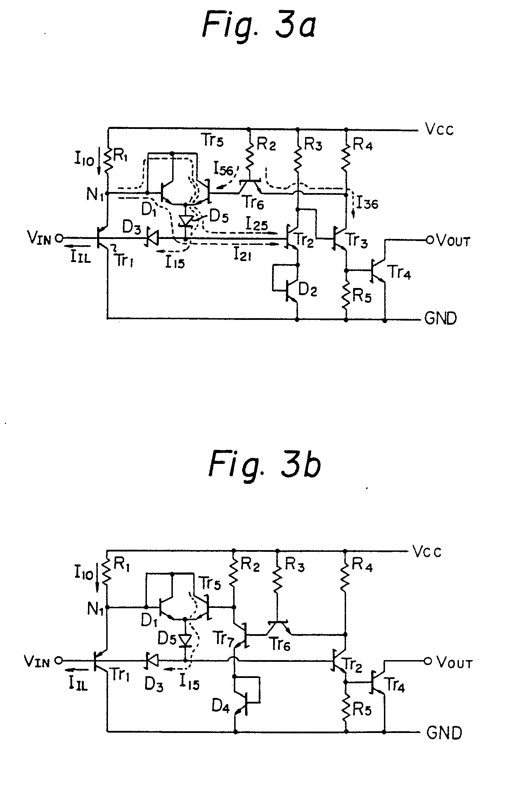

Figures 3a and 3b illustrate examples of non-inverting type and inverting type Schmitt trigger circuits embodying the present invention, respectively.

The Schmitt trigger circuits of Figures 3a and 3b have the same constitution as the circuits of Figures 1a and 1b, respectively, except that a Schottky barrier diode $D_5$ is connected in the forward direction between the anode of the diode $D_3$ and the emitter of the transistor $Tr_5$.

Hereinafter, the operation of the non-inverting type Schmitt trigger circuit of Figure 3a is explained. While the input voltage $V_{IN}$=L ($V_{IN}$=0 volt), the transistor $Tr_1$ is in the on state, and thus, the voltage $V_{N1}$ at the node $N_1$ is $V_{N1}$=$V_{BE}$. Since the diodes $D_1$ and $D_5$ of which the forward voltage drops are $V_{BE}$ and $V_F$ respectively, are connected between the node $N_1$ and the base of the transistor $Tr_2$, the voltage at the base of the transistor $Tr_2$ is zero and, thus, the transistor $Tr_2$ is in the off state in this case. In order to turn on the transistor $Tr_2$, the voltage $V_{N1}$ at the node $N_1$ should be

$$V_{N1} \gtreqless 3V_{BE} + V_F,$$

for reasons similar to those given earlier with reference to Figure 1a. That is, if the input voltage $V_{IN}$ is

$$V_{IN} \gtreqless 2V_{BE} + V_F,$$

the transistor $Tr_2$ will turn on. In other words, the threshold voltage $V_H$ as $V_{IN}$ rises is $V_H$=$2V_{BE}$+$V_F$. The output voltage $V_{out}$ is low (L) when $V_{IN}$=L as in the case of Figure 1a.

When the input voltage $V_{IN}$ is increased from $V_{IN}$=L to $V_{IN}$=$2V_{BE}$+$V_F$ (in this case $V_{N1}$=$3V_{BE}$+$V_F$), the transistor $Tr_2$ starts to turn on. The base current of the transistor $Tr_2$ at this time is supplied through the load resistor $R_1$ and the diodes $D_1$ and $D_5$ as indicated by $I_{21}$ in Figure 3a. When the transistor $Tr_2$ turns on, the transistor $Tr_4$ turns off, causing the output voltage $V_{out}$ to change to the H level. Furthermore, the current $I_{56}$ flows from the transistor $Tr_6$ to the transistor $Tr_5$ to turn on the transistor $Tr_5$. Since the collector to emitter voltage $V_{CE}$ of the on-state transistor $Tr_5$ is lower than the forward voltage drop $V_{BE}$ of the diode $D_1$, base current to the transistor $Tr_2$ is supplied through the resistor $R_1$, the collector emitter path of the transistor $Tr_5$, and the diode $D_5$ as indicated by $I_{25}$ after the transistor $Tr_5$ turns on, instead of $I_{21}$. While $V_{IN}$=H, the above state is maintained.

When the input voltage $V_{IN}$ changes from $V_{IN}$=H to $V_{IN}$=L, the transistor $Tr_2$ turns off. This turning off occurs when the voltage $V_{N1}$ at the node $N_1$ decreases to a value equal to or lower than

$$V_{CE}+2V_{BE}+V_F,$$

which is the sum of the collector emitter voltage $V_{CE}$ of the transistor $Tr_5$, the forward voltage $V_F$ of the diode $D_5$, and the forward voltages $V_{BE}$ of the transistor $Tr_2$ and of the diode $D_2$. Therefore, when the input voltage $V_{IN}$ reaches a value

$$V_{IN}=V_{BE}+V_{CE}+V_F,$$

transistor $Tr_2$ turns off. In other words, the threshold voltage $V_L$, as $V_{IN}$ falls, is

$$V_L=V_{BE}+V_{CE}+V_F.$$

According to the Schmitt trigger circuit of Figure 3a, the abrupt and substantial increase of the input current $I_{IL}$ at the falling of the input voltage $V_{IN}$ can be prevented. The reason for this is as follows. As aforementioned, the abrupt increase $I_{IL}$ is due to the existence of the current $I_{15}$ which flows through the collector to the emitter of the transistor $Tr_5$ and the diode $D_3$. In the circuit of Figure 3a, voltage along the route of the current $I_{15}$ is

$$V_{CETr_5}+V_{FD5}+V_{FD3},$$

where

$V_{CETr_5}$ is the collector to emitter voltage of the transistor $Tr_5$ and $V_{FD5}$ and $V_{FD3}$ are the forward voltage drops of the diodes $D_5$ and $D_3$, respectively. It is clear that this voltage of

$$V_{CETr_5}+V_{FD5}+V_{FD3}$$

is higher than the base to emitter voltage

$$V_{BETr_1}$$

of the transistor $Tr_1$. That is there is a relationship of

$$V_{BETr_1}<V_{CETr_5}+V_{FD5}+V_{FD3}$$

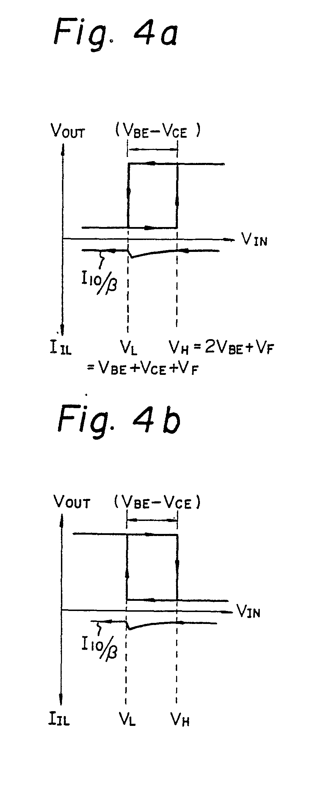

Therefore, according to the circuit of Figure 3a, the current $I_{15}$ is very low even when the input voltage $V_{IN}$ falls, as shown in Figure 4a. The base of the transistor $Tr_2$ is discharged in the same way as in the conventional circuit of Figure 1a.

In the inverting type Schmitt trigger circuit of Figure 3b, an abrupt and substantial increase of input current $I_{IL}$ at the falling of $V_{IN}$ is prevented, as shown in Figure 4b, in the same way as in the circuit of Figure 3a.

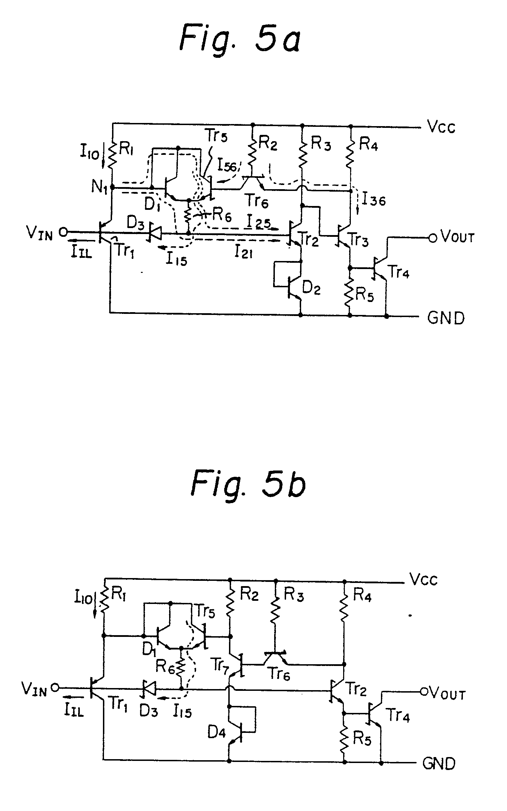

Figures 5a and 5b illustrate other examples of non-inverting type and inverting type Schmitt trigger circuits embodying the present invention. The Schmitt trigger circuits of Figures 5a and 5b have almost the same constitution as those of the respective circuits of Figures 3a and 3b, except that a resistor $R_6$ is used instead of the diode $D_5$. The resistance of the resistor $R_6$ is designed so that voltage drop across the resistor $R_6$ is almost equal to $V_F$ (e.g. about 0.4V). The circuits of Figures 5a and 5b operate similarly to those of Figures 3a and 3b respectively.

As will be apparent from the description hereinbefore, in the illustrated Schmitt trigger circuits embodying the present invention, a level shift element such as the diode $D_5$ or the resistor $R_6$ is connected between the transistor $Tr_5$ and the anode of the diode $D_3$. In this manner a troublesome surge of the input current $I_{IL}$ at the falling of the input voltage can be prevented. Accordingly, a preceding stage connected to such a circuit does not have to cope with such surges, and a relatively large number of such Schmitt trigger circuits can be connected to that preceding circuit (large fan-out).

**Claims**

1. A Schmitt trigger circuit having:

an input stage comprising an input transistor $(Tr_1)$ providing a controllable path, controlled by a first control electrode of the transistor, which path is connected in series with a load resistor $(R_1)$ between first and second power lines $(V_{CC}, GND)$;

an output stage $(Tr_4)$ connected between an output point and one $(GND)$ of the first and second power supply lines;

a control arrangement, including a second transistor $(Tr_2)$ having a second control electrode connected to the said first control electrode by way of a first diode $(D_3)$, such that the second transistor $(Tr_2)$ is switched on or off, when the circuit is in use, in dependence upon an input signal $(V_{IN})$ applied to the first control electrode, which arrangement provides a controllable path connected to control the said output stage $(Tr_4)$ so that the output stage is switched between first and second states $(L, H)$ in dependence upon the said input signal; and

hysteresis circuitry $(D_1, Tr_5, Tr_6)$ providing two alternative parallel unidirectional current paths $(I_{25}, I_{21})$, comprising respectively a second diode $(D_1)$ and a third transistor $(Tr_5)$, for conducting current $(I_{10})$ in the same direction between said load resistor and one end of a common path, the other end of which is connected to the anode of the said first diode $(d_3)$, and to the said second control electrode, which hysteresis circuitry includes path control means $(Tr_6)$ coupled to the said controllable path of the said control arrangement and operative in dependence thereon to ensure that the said third transistor $(Tr_5)$ conducts such current when the said input signal $(V_{IN})$ is decreasing and to ensure that the said second diode $(D_1)$ conducts such current when the input signal $(V_{IN})$ is increasing, the respective voltage drops along the said alternative current paths being different from one another so as to provide respective different threshold voltages $(V_H, V_L)$ for Schmitt trigger switching of the output stage $(Tr_4)$;

characterised by level shift means $(D_5; R_6)$ connected in the said common path for introducing a further voltage drop in series with that one of the said alternative current paths which is conducting current, thereby to reduce current ($I_{15}$) flowing along the said common path, and through the said first diode ($D_3$) to the first control electrode, while the said signal ($V_{IN}$) applied to the first control electrode is decreasing.

2. A Schmitt trigger circuit as claimed in Claim 1, wherein said level shift means comprises a third doide ($D_5$) connected to conduct in the direction towards the anode of the said first diode ($D_3$).

3. A Schmitt trigger circuit as claimed in Claim 1, wherein said level shift means comprises a resistor.

4. A Schmitt trigger circuit as claimed in Claim 1, 2 or 3, in which the said control arrangement includes a fourth transistor ($Tr_3$) connected to the second transistor ($Tr_2$) so as to be turned on when the second transistor is turned off, the fourth transistor ($Tr_3$) providing the said controllable path of the control arrangement, and in which the said path control means comprises a fifth transistor ($Tr_6$) connected to a control electrode of the third transistor ($tr_5$) to turn it on when the fourth transistor ($Tr_3$) is turned off.

5. A schmitt trigger circuit as claimed in Claim 1, 2 or 3, in which the collector-emitter path of the said second transistor ($Tr_2$) provides the said controllable path of the control arrangement, and in which the said path control means includes a further transistor ($Tr_7$) and a diode ($D_4$) connected in series between the first and second power supply lines, the controllable path of the further transistor ($Tr_7$) being connected to control the third transistor ($Tr_5$) and being itself controlled by an additional transistor ($Tr_6$) connected between the control electrode of the further transistor ($Tr_7$) and the said controllable path of the control arrangement.

**Patentansprüche**

1. Schmitt-Trigger-Schaltung mit:

einer Eingangsstufe, die einen Eingangstransistor ($Tr_1$) umfaßt, der einen steuerbaren Weg vorsieht, gesteuert durch eine erste Steuerelektrode des Transistors, welcher Weg in Reihe mit einem Lastwiderstand ($R_1$) zwischen ersten und zweiten Energieversorgungsleitungen ($V_{CC}$, GND) verbunden ist;

einer Ausgangsstufe ($Tr_4$), die zwischen einem Ausgangspunkt und einer (GND) der ersten und zweiten Energievorsorgungsleitungen verbunden ist;

einer Steueranordnung, die einen zweiten Transistor ($Tr_2$) umfaßt, der eine zweite Steuerelektrode hat, die mit der genannten ersten Steuerelektrode über eine erste Diode ($D_3$) so verbunden ist, daß der genannte zweite Transistor ($Tr_2$) ein- oder ausgeschaltet wird, wenn die Schaltung in Betrieb ist, in Abhängigkeit von einem Eingangssignal ($V_{IN}$), welches der ersten Steuerelektrode zugeführt wird, welche Anordnung einen steuerbaren Weg vorsieht, der angeschlossen ist, um die genannte Ausgangsstufe ($Tr_4$) so zu steuern,

daß die Ausgangsstufe, abhängig von dem genannten Eingangssignal, zwischen ersten und zweiten Zuständen (L, H) geschaltet wird; und

einer Hysteresis-Schaltung ($D_1$, $Tr_5$, $Tr_6$), die zwei alternative, parallele, gleichgerichtete Stromwege ($I_{25}$, $I_{21}$) vorsieht, die jeweils eine zweite Diode ($D_1$) und einen dritten Transistor ($Tr_5$) umfassen, um einen Strom ($I_{10}$) in der selben Richtung zwischen dem genannten Lastwiderstand und einem Ende eines gemeinsamen Weges zu lieten, dessen anderes Ende mit der Anode der genannten ersten Diode ($D_3$) und mit der genannten zweiten Steuerelektrode verbunden ist, welche Hysteresis-Schaltung eine Wegsteuereinrichtung ($Tr_6$) umfaßt, die mit dem genannten steuerbaren Weg der genannten Steueranordnung gekoppelt und in Abhängigkeit davon betriebbar ist, um zur gewährleisten, daß der genannte dritte Transistor ($Tr_5$) solch einen Strom leitet, wenn das genannte Eingangssignal ($V_{IN}$) kleiner wird, und um zu gewährleisten, daß die genannte zweite Diode ($D_1$) solch einen Strom leitet, wenn das Eingangssignal ($V_{IN}$) größer wird, wobei die jeweiligen Spannungsabfälle längs den genannten alternativen Stromwegen voneinander verschieden sind, um so jeweils verschiedene Schwellenwertspannungen ($V_H$, $V_L$) für die Schmitt-Trigger-Schaltung der Ausgangsstufe ($Tr_4$) zu liefern;

gekennzeichnet, durch Pegelverschiebeeinrichtungen ($D_5$; $R_6$), die mit dem genannten gemeinsamen Weg verbunden sind, zur Einführung eines weiteren Spannungsabfalls in Reihe mit jenem einen der genannten alternativen Stromwege, welcher einen Strom leitet, um dadurch den Strom ($I_{15}$) zu reduzieren, der längs dem genannten gemeinsamen Weg und durch die genannte erste Diode ($D_3$) zu der ersten Steuerelektrode fleißt, während das genannte Signal ($V_{IN}$), welches der ersten Steuerelektrode zugeführt wird, kleiner wird.

2. Schmitt-Trigger-Schaltung nach Anspruch 1, bei der die genannte Pegelverschiebeeinrichtung eine Dritte Diode ($D_5$) umfaßt, die verbunden ist, um in Richtung zu der Anode der genannten ersten Diode ($D_3$) zu leiten.

3. Schmitt-Trigger-Schaltung nach Anspruch 1, bei der die genannte Pegelverschiebeeinrichtung einen Widerstand umfaßt.

4. Schmitt-Trigger-Schaltung nach Anspruch 1, 2 oder 3, bei der die genannte Steueranordnung einen vierten Transistor ($Tr_3$) umfaßt, der mit dem zweiten Transistor ($Tr_2$) so verbunden ist, daß der eingeschaltet wird, wenn der genannte zweite Transistor ausgeschaltet wird, der vierte Transistor ($Tr_3$) den genannten steuerbaren Weg der Steueranordnung vorsieht, und bei der die genannte Wegsteuereinrichtung einen fünften Transistor ($Tr_6$) umfaßt, der mit einer Steuerelektrode des dritten Transistors ($Tr_5$) verbunden ist, um sie einzuschalten, wenn der vierte Transistor ($Tr_3$) ausgeschaltet wird.

5. Schmitt-Trigger-Schaltung nach Anspruch 1, 2 oder 3, bei der der Kollektor-Emitter-Weg des genannten zweiten Transistors ($Tr_2$) den genann-

ten steuerbaren Weg der Steueranordnung vorsieht, und bei der die genannte Wegsteuereinrichtung einen weiteren Transistor (Tr$_7$) und eine Diode (D$_4$) umfaßt, die in Reihe zwischen den genannten ersten und zweiten Energieversorgungsleitungen verbunden sind, der steuerbare Weg des weiteren Transistors (Tr$_7$) verbunden ist, um den dritten Transistor (Tr$_5$) zu steuern und selber durch einen zusätzlichen Transistor (Tr$_6$) gesteuert zu werden, der zwischen der Steuerelektrode des dritten Transistors (Tr$_7$) und dem genannten steuerbaren Weg der Steueranordnung verbunden ist.

**Revendications**

1. Circuit basculeur de Schmitt comprenant:

un étage d'entrée comportant un transistor d'entrée (Tr$_1$) qui offre un trajet ajustable, commandé par une première électrode de commande du transistor, lequel trajet est connecté en série avec une résistance de charge (R$_1$) entre des première et deuxième lignes d'alimentation (V$_{CC}$, GND);

un étage de sortie (Tr$_4$) connecté entre un point de sortie et l'une (GND) des première et deuxième lignes d'alimentation;

un dispositif de commande, qui comporte un deuxième transistor (Tr$_2$) possédant une deuxième électrode de commande connectée à ladite première électrode de commande par l'intermédiaire d'une première diode (D$_3$), de sorte que le deuxième transistor (Tr$_2$) est bloqué ou débloqué, lorsque le circuit est en fonctionnement, en fonction d'un signal d'entrée (V$_{IN}$) appliqué à la première electrode de commande, lequel dispositif offre un trajet adjustable connecté de façon à commander ledit étage de sortie (Tr$_4$) de sorte que l'étage de sortie est commuté entre des premier et deuxième états (L, H) en fonction dudit signal d'entrée; et

un circuit à hystérésis (D$_1$, Tr$_5$, Tr$_6$) qui offre deux trajets de courant unidirectionnels parallèles possibles (I$_{25}$, I$_{21}$), comprenant respectivement une deuxième diode (D$_1$) et un troisième transistor (Tr$_5$), afin de conduire un courant (I$_{10}$) dans le même sens entre ladite résistance de charge et une première extrémité d'un trajet commun, l'autre extrémité étant connectée à l'anode de ladite première diode (D$_3$), et à ladite deuxième électrode de commande, le circuit à hystérésis comprenant des moyens (Tr$_6$) de commande de trajet qui sont couplés audit trajet ajustable dudit dispositif de commande et sont rendus actifs en fonction de celui-ci afin d'assurer que le troisième

transistor (Tr$_5$) conduit ce courant quand ledit signal d'entrée (V$_{IN}$) décroît et d'assurer que la deuxième diode (D$_1$) conduit ce courant quand le signal d'entrée (V$_{IN}$) s'accroît, les chutes de tension respectives le long desdits trajets de courant possibles étant différentes l'une de l'autre de façon à fournir respectivement des tension de seuil différentes (V$_H$, V$_L$) pour la commutation du basculeur de Schmitt de l'étage de sortie (Tr$_4$);

caractérisé par des moyens de déplacement de niveau (D$_5$; R$_6$) connectés dans ledit trajet commun afin d'introduire une chute de tension supplémentaire en série avec la chute de tension de celui des deux trajets de courant possibles qui conduit un courant, ce qui réduit le courant (I$_{15}$) circulant le long dudit trajet commun et, via ladite première diode (K$_3$), jusqu'à la première électrode de commande, pendant que ledit signal (V$_{IN}$) appliqué à la première électrode de commande décroît.

2. Circuit basculeur de Schmitt selon la revendication 1, où lesdits moyens de déplacement de niveau comprennent une troisième diode (D$_5$) connectée de façon à conduire vers l'anode de ladite première diode (D$_3$).

3. Circuit basculeur de Schmitt selon la revendication 1, où lesdits moyens de déplacement de niveau comprennent une résistance.

4. Circuit basculeur de Schmitt selon la revendication 1, 2 ou 3, dans lequel ledit dispositif de commande comporte un quatrième transistor (Tr$_3$) connecté au deuxième transistor (Tr$_2$) de façon à être débloqué quand le deuxième transistor est bloqué, le quatrième transistor (Tr$_3$) offrant ledit trajet ajustable du dispositif de commande, et dans lequel lesdits moyens de commande du trajet comprennent un cinquième transistor (Tr$_6$) connecté à une électrode de commande du troisième transistor (Tr$_5$) pour le débloquer lorsque le quatrième transistor (Tr$_3$) est bloqué.

5. Circuit basculeur de Schmitt selon la revendication 1, 2 ou 3, dans lequel le trajet collecteur-émetteur dudit deuxième transistor (Tr$_2$) offre ledit trajet adjustable du dispositif de commande, et dans lequel lesdits moyens de commande de trajet comportent une transistor supplémentaire (Tr$_7$) et une diode (D$_4$) connectés en série entre la première et la deuxième ligne d'alimentation, le trajet adjustable du transistor supplémentaire (Tr$_7$) étant connecté de façon à commander le troisième transistor (Tr$_5$) et étant lui-même commandé par un transistor supplémentaire (Tr$_6$) connecté entre l'électrode de commande du transistor supplémentaire (Tr$_7$) et ledit trajet adjustable du dispositif de commande.

## Fig. 1a

## Fig. 1b

# Fig. 2a

# Fig. 2b

## Fig. 3a

## Fig. 3b

# Fig. 4a

$V_{OUT}$    $(V_{BE}-V_{CE})$

$V_{IN}$

$I_{10}/\beta$

$I_{IL}$      $V_L$     $V_H = 2V_{BE}+V_F$

       $= V_{BE}+V_{CE}+V_F$

# Fig. 4b

$V_{OUT}$    $(V_{BE}-V_{CE})$

$V_{IN}$

$I_{10}/\beta$

$I_{IL}$      $V_L$     $V_H$

## Fig. 5a

## Fig. 5b